# EUROPÄISCHE PATENTANMELDUNG

(11) **EP 1 139 411 A1**
(43) Veröffentlichungstag der Anmeldung: **04.10.2001**
(21) Anmeldenummer: 00106731.3
(22) Anmeldetag: 29.03.2000
(51) Int. Cl.: H01L 21/60, H01L 23/31

(54) **Flip-chip Halbleiter-Anordnung mit Rückseiten-Kontaktierung**

(71) Anmelder: Infineon Technologies AG, 81541 München (DE)
(72) Erfinder: Neugebauer, Frank, Dipl.-Phys., 81375 München (DE)
(74) Vertreter: Fischer, Volker, Dipl.-Ing.

(57) **Zusammenfassung**

Ein Halbleiterchip (10) ist mittels Flip-Chip-Montage mit dem Substrat (5) zugewandten Anschlusskontakten auf dem Substrat befestigt. Ein weiterer Halbleiterchip (11) ist mit seiner nicht mit einem Bauelement versehenen Rückseite dauerhaft mit der ebenfalls nicht mit einem Bauelement versehenen Rückseite des ersten Halbleiterchips mittels einer Kleberschicht (2) verbunden. Die Anschlusskontakte der in dem zweiten Halbleiterchip vorhandenen Bauelemente auf der von dem Substrat abgewandten Seite sind mittels Bonddrähten (6) mit dafür vorgesehenen Kontaktflächen des Substrates elektrisch leitend verbunden.

## Beschreibung

Die vorliegende Erfindung betrifft eine Anordnung als neuartiges Multichip-Gehäuse für Halbleiterbauelemente.

Halbleiterchips werden auf Substraten angebracht, die für den weiteren Einbau der Chips konzipiert sind. Diese Anordnungen von Halbleiterchips und Substraten oder Trägerrahmen werden als Gehäuse (Package) bezeichnet. Sollen mehrere Halbleiterchips in demselben Gehäuse untergebracht werden, bestehen alternativ die Möglichkeiten, die Chips in derselben Ebene nebeneinander anzuordnen oder vertikal zu stapeln. Eine Verbindung beider Möglichkeiten besteht in der Flip-on-Chip-Montage, bei der Halbleiterchips, die nebeneinander angeordnet sind, mit ihren Anschlusskontaktflächen auf den Anschlusskontakten eines weiteren Halbleiterchips größerer Fläche nach Art einer Flip-Chip-Montage angebracht werden. Dieser weitere, ebenfalls mit einer aktiven integrierten Schaltung versehene Halbleiterchip wird dann mittels Bonddrähten mit einem weiteren Substrat, z. B. einem Leiterrahmen, verbunden.

Die Anordnung mehrerer Chips nebeneinander benötigt eine große Substratfläche. Der mit der vertikalen Anordnung erreichte kompaktere Aufbau besitzt den Nachteil, dass die übereinander gestapelten Chips in der Größe so aneinander angepasst sein müssen, dass die Anschlusskontakte der in dem Stapel weiter unten angeordneten Chips nicht verdeckt werden und dass bei beidseitiger Kontaktierung die jeweils elektrisch leitend miteinander zu verbindenden Anschlusskontakte übereinander zu liegen kommen. Das erschwert es insbesondere, von verschiedenen Herstellern gelieferte Chips miteinander zu verbinden. Bei der Flip-on-Chip-Montage ist ebenfalls für den unteren Chip eine große Fläche erforderlich; außerdem besteht hier die Gefahr der Überkopplung von Signalen zwischen den Chips.

Aufgabe der vorliegenden Erfindung ist es, eine einfach herstellbare Anordnung als Gehäuse für eine Mehrzahl von Halbleiterchips anzugeben.

Diese Aufgabe wird mit der Anordnung mit den Merkmalen des Anspruches 1 gelöst. Ausgestaltungen ergeben sich aus den abhängigen Ansprüchen.

Bei der erfindungsgemäßen Anordnung ist ein Halbleiterchip mittels Flip-Chip-Montage mit dem Substrat zugewandten Anschlusskontakten auf dem Substrat befestigt. Ein weiterer Halbleiterchip ist mit seiner nicht mit einem Bauelement versehenen Rückseite dauerhaft mit der ebenfalls nicht mit einem Bauelement versehenen Rückseite des ersten Halbleiterchips verbunden. Die Anschlusskontakte der in dem zweiten Halbleiterchip vorhandenen Bauelemente sind in dieser Anordnung daher auf der von dem Substrat abgewandten Seite der Halbleiterchips angeordnet. Diese weiteren Anschlusskontakte des zweiten (bezüglich des Substrates oberen) Halbleiterchips sind mittels Bonddrähten mit dafür vorgesehenen Kontaktflächen des Substrates elektrisch leitend verbunden. Statt aus einer Verbindung zweier Halbleiterchips kann die erfindungsgemäße Anordnung mit einem zweiseitig prozessierten Halbleiterchip aufgebaut sein, d. h. mit einem Halbleiterchip mit Bauelementen, die in oder an zwei einander gegenüberliegenden Hauptseiten angeordnet oder integriert sind.

Es folgt eine genauere Beschreibung der erfindungsgemäßen Anordnung anhand der in den beigefügten Figuren im Querschnitt dargestellten Ausführungsbeispiele.
- Figur 1: zeigt eine Anordnung mit BGA.
- Figur 2: zeigt eine Anordnung mit Lead-Frame.
- Figur 3: zeigt eine Anordnung mit beidseitig prozessiertem Chip.

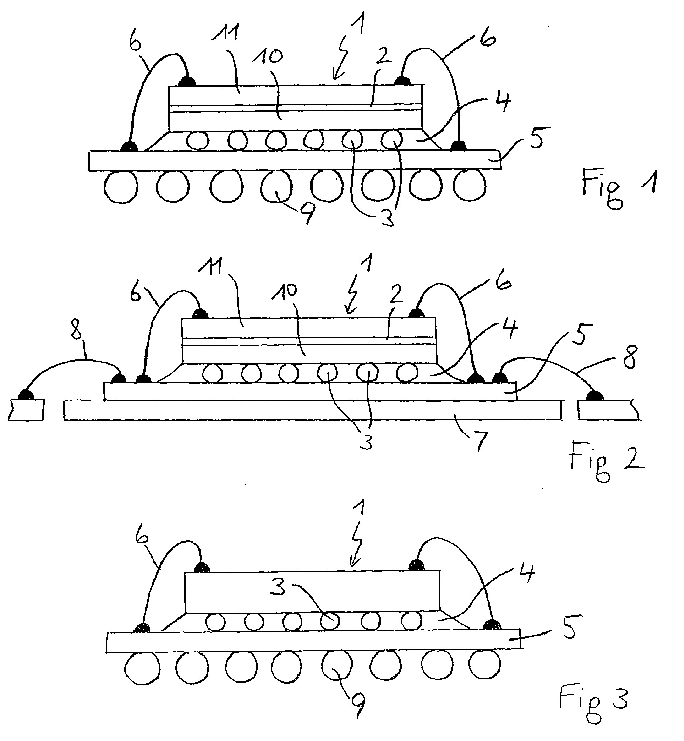

In Figur 1 ist eine Anordnung dargestellt, bei der ein Halbleiterchip 1 auf einem Substrat 5 montiert ist. Der Halbleiterchip 1 ist zusammengesetzt aus zwei einzelnen Chips: einem unteren ersten Halbleiterchip 10 und einem oberen zweiten Halbleiterchip 11. Diese Halbleiterchips 10, 11 sind mit ihren Rückseiten, d. h. mit zwei Hauptseiten, die keine Bauelemente tragen, dauerhaft aneinander befestigt. Das kann z. B. durch eine Klebstoffschicht 2 bewirkt sein. Die mit dieser Klebstoffschicht aneinander gefügten Oberflächen sind vorzugsweise mit einer jeweiligen Metallisierung versehen.

Die elektrische Kontaktierung mit Anschlussflächen des Substrates 5 geschieht in diesem Beispiel mit den in der Figur 1 im Querschnitt eingezeichneten Lotkugeln 3. Diese Art der Montage wird als Flip-Chip-Montage bezeichnet und ist an sich bekannt. Bei dieser Art der Montage und elektrischen Kontaktierung wird ein Halbleiterchip mit der mit Bauelementen versehenen Oberseite so einem Substrat zugewandt, dass die auf der Oberseite des Halbleiterchips vorhandenen Anschlusskontakte den zugeordneten Kontaktflächen des Substrates gegenüberliegen. Die jeweils einander gegenüberliegenden Kontakte werden dann miteinander elektrisch leitend verbunden, was vorzugsweise durch an den betreffenden Stellen aufgebrachte kleine Mengen eines Lotes geschieht. Dabei handelt es sich in der Regel um ein Weichlot, das unter geringfügiger Erwärmung beim Anpressen eine dauerhafte leitende Verbindung zwischen den Anschlusskontakten herstellt. Die Zwischenräume zwischen den Lotkugeln 3 können durch eine Vergussmasse oder Füllmasse 4 (sogenanntes Underfill) ausgefüllt sein.

Bei der erfindungsgemäßen Anordnung sind die Anschlusskontakte des oberen zweiten Halbleiterchips 11 auf der von dem Substrat 5 abgewandten Seite dieses zweiten Halbleiterchips 11 vorhanden. Diese weiteren Anschlusskontakte, die nicht bereits mit der Flip-Chip-Montage kontaktiert sind, sind mittels Bonddrähten 6 mit zugeordneten Kontaktflächen des Substrates elektrisch leitend verbunden. Der Übersichtlichkeit halber sind in Figur 1 nur zwei solche Bonddrähte 6 eingezeichnet. Eine weitere Montage oder ein elektrischer Anschluss des Substrates 5 kann in einer an sich bekannten Weise durch eine Lotkugelanordnung 9 erfolgen (BGA, Ball Grid Array).

In Figur 2 ist eine andere Ausführungsform der Anordnung dargestellt, bei der der montierte Halbleiterchip 1 ebenfalls aus einem ersten Halbleiterchip 10 und einem zweiten Halbleiterchip 11 zusammengesetzt ist. Die Verbindung der jeweiligen Rückseiten dieser Halbleiterchips ist in Figur 2 wieder durch eine eingezeichnete Klebstoffschicht 2 angedeutet. Die Flip-Chip-Montage des unteren ersten Halbleiterchips 10 ist auch hier schematisch durch die eingezeichneten Lotkugeln 3 kenntlich gemacht. Während die weiteren Anschlusskontakte des oberen zweiten Halbleiterchips 11 wieder mit Bonddrähten 6 mit zugeordneten Kontaktflächen des Substrates 5 verbunden sind, ist für einen externen Anschluss das Substrat 5 hier auf einem Leiterrahmen (lead frame) angebracht, der über in der Form angepasste elektrische Leiter verfügt, die mit entsprechenden Anschlusskontakten des Substrates 5 über weitere Bonddrähte 8 elektrisch leitend verbunden sind.

Aus den Ausführungsbeispielen gemäß den Figuren 1 und 2 ist erkennbar, dass die erfindungswesentlichen Merkmale der Anordnung darin zu sehen sind, dass Anschlusskontakte auf der dem Substrat zugewandten Seite und weitere Anschlusskontakte auf der von dem Substrat abgewandten Seite der Chipanordnung einerseits durch eine direkte elektrisch leitenden Verbindung nach Art einer Flip-Chip-Montage bzw. andererseits über Bonddrähte mit zugeordneten Kontaktflächen des Substrates verbunden sind. Dafür, wie der Einbau dieses Substrates in oder auf weiteren Trägern oder Gehäusen und die zugehörigen elektrischen Anschlüsse ausgeführt sind, ergeben sich aus den erfindungswesentlichen Merkmalen keine Einschränkungen. Die beschriebenen Ausführungsbeispiele BGA-Package und Lead-Package können daher um weitere Montagearten ergänzt werden. In jedem Fall werden die montierten Halbleiterchips so angeordnet oder ausgestaltet, dass auf beiden Hauptseiten des gesamten Halbleiterchips 1 Anschlusskontakte vorhanden sind.

Es ist daher nicht erforderlich, dass der Halbleiterchip 1 tatsächlich aus zwei getrennt hergestellten Halbleiterchips zusammengesetzt ist. Es ist vielmehr auch entsprechend Figur 3 möglich, eine erfindungsgemäße Anordnung mit einem integralen Halbleiterchip mit beidseitig angeordneten Bauelementen mit Anschlusskontakten oder zumindest mit Durchkontaktierungen und beidseitig angeordneten Anschlusskontakten zu realisieren. Bei dem Ausführungsbeispiel gemäß Figur 3 ist eine solche Anordnung mit integralem Halbleiterchip für das Beispiel einer BGA-Package (Lotkugelanordnung 9) dargestellt. Dieses Ausführungsbeispiel gemäß Figur 3 löst außerdem die zusätzliche Aufgabe, eine Anordnung als Gehäuse für die Montage eines zweiseitig prozessierten Halbleiterchips anzugeben.

Die erfindungsgemäße Anordnung hat die Vorteile, dass der obere zweite Halbleiterchip 11 bei den Ausführungsbeispielen mit zusammengesetztem Halbleiterchip 1 größer gewählt werden kann als der untere erste Halbleiterchip 10. Die seitlichen Abmessungen und die Dicke der Halbleiterchips brauchen nicht wie in der vereinfachten Darstellung der Figuren 1 und 2 übereinzustimmen. Ein Halbleiterchip eines anderen Herstellers kann einfacher integriert werden, weil durch die getrennten Kontaktierungen der zum Substrat hin angeordneten Anschlusskontakte und der auf der Gegenseite liegenden weiteren Anschlusskontakte eine Umstrukturierung der Anordnung der Kontaktflächen auf dem Substrat 5 ohne weiteres möglich ist. Im Vergleich zu einer Montage als Flip-on-Chip (Flip-Chip-Montage von Halbleiterchips auf einem weiteren aktiven, d. h. mit integrierten Schaltungen versehenen Halbleiterchip) wird weniger Chipfläche benötigt, da nur vertikal integriert wird.

## Patentansprüche

1. Anordnung als Gehäuse für Halbleiterchips mit
- einem Substrat (5) mit Kontaktflächen für elektrische Kontaktierung,
- einem Halbleiterchip (10) mit Anschlusskontakten, die den Kontaktflächen des Substrates (5) zugewandt sind, und
- elektrisch leitenden Verbindungen (3) zwischen den Kontaktflächen und den Anschlusskontakten,
- **dadurch gekennzeichnet, dass**
- weitere Anschlusskontakte auf der von dem Substrat (5) abgewandten Seite des Halbleiterchips (10) vorhanden sind und
- die weiteren Anschlusskontakte mit Kontaktflächen des Substrates (5) über Bonddrähte (6) elektrisch leitend verbunden sind.

2. Anordnung nach Anspruch 1, bei der
- die weiteren Anschlusskontakte an einem weiteren Halbleiterchip (11) auf der von dem Substrat (5) abgewandten Seite des weiteren Halbleiterchips (11) vorhanden sind und
- die Halbleiterchips (10, 11) mit jeweiligen Oberseiten, die den Anschlusskontakten bzw. weiteren Anschlusskontakten gegenüberliegen, aneinander befestigt sind.

3. Anordnung nach Anspruch 2, bei der
die Oberseiten der Halbleiterchips (10, 11), mit denen die Halbleiterchips (10, 11) aneinander befestigt sind, jeweils mit einer Metallisierung versehen sind.

4. Anordnung nach einem der Ansprüche 1 bis 3, bei der
das Substrat (5) mit einer Lotkugelanordnung (9) als BGA versehen ist.

5. Anordnung nach einem der Ansprüche 1 bis 3, bei der das Substrat (5) mit einem Leiterrahmen (7) versehen ist.
